**Europäisches Patentamt**

**European Patent Office**

**Office européen des brevets**

(19)

(11) Publication number : **0 371 147 B1**

# EUROPEAN PATENT SPECIFICATION

(12)

(45) Date of publication of patent specification :
19.05.93 Bulletin 93/20

(51) Int. Cl.⁵ : **C09K 3/14, H01L 21/304**

(21) Application number : **89906447.1**

(22) Date of filing : **02.06.89**

(86) International application number :
**PCT/JP89/00558**

(87) International publication number :
**WO 89/12082 14.12.89 Gazette 89/29**

(54) **ABRASIVE COMPOSITION FOR SILICON WAFER.**

(30) Priority : 03.06.88 JP 135451/88
22.03.89 JP 169881/89

(43) Date of publication of application :
06.06.90 Bulletin 90/23

(45) Publication of the grant of the patent :
19.05.93 Bulletin 93/20

(84) Designated Contracting States :
BE DE FR GB IT

(56) References cited :
DE-A- 1 812 687
DE-A- 2 901 401
JP-A- 6 230 333
US-A- 3 170 273

(73) Proprietor : **MONSANTO JAPAN LIMITED**
1-1, Marunouchi 3-chome, Chiyoda-ku
Tokyo (JP)

(72) Inventor : **Sasaki, Shigeo c/o Mitsubishi
Monsanto Chem. Co.,
Yokkaichi Research Laboratory, 1, Toho-cho
Yokkaichi-shi, Mie-ken 510 (JP)**

(74) Representative : **Myerscough, Philip Boyd et al
J.A.Kemp & Co. 14, South Square Gray's Inn
London, WC1R 5EU (GB)**

## Description

### Field of the Invention

This invention relates to a silicon wafer polishing compound for polishing a silicon wafer used as a substrate in electrical integrated circuits, more specifically, to a silicon wafer polishing compound which has substantially reduced damages to the surface of the silicon wafer.

### Description of the Prior Art

Silicon wafers used as substrates in the production of electrical integrated circuits are surface-polished and then subjected to the formation of circuits.

There have heretofore been proposed various types of polishing compounds for polishing the surface of silicon wafers. For example, in the specification of U.S. Patent 3,170,273, a silica sol having a silica concentration of 2 to 50% by weight and a silica gel having a silica concentration of 2 to 100% by weight are disclosed as polishing compounds. The specification of USP 3,328,141 discloses that the polishing speed is increased by mixing these polishing compounds with an alkaline compound to adjust the pH value to 10.5 to 12.5.

For polishing silicon wafers, colloidal silica sol is widely used for its small particle sizes over silica gel fine particles.

However, colloidal silica sol, because it has chemically active silanol groups in a high density on the surface of silica particles, tends to undergo gelation during drying or produce coarse silica particle agglomerations in the sol. When the polishing slurry is contaminated with a gelled matter from the slurry supply or coarse silica particle agglomerations are present, the polishing slurry tends to cause scratches or latent flaws on silicon wafers during polishing.

These scratches and latent flaws present on the silicon wafers are not preferable since they lead to uneven electrical electrical characteristics of circuits when the circuit patterns are formed on the surface of the silicon wafers using oxide film formation, etching, and doping techniques.

Therefore, the polishing slurry must be strictly controlled so as not to be contaminated with dried gelation products or coarse silica particle agglomerations, but there is no method for checking the polishing slurry whether or not it is contaminated with dried gelation products or coarse silica particle agglomerations, which can only be determined from the polished silicon wafers.

With a view to eliminate the above prior art problems, it is a primary object of the present invention to provide a silicon wafer polishing compound, in which silica particles in a colloidal silica sol is modified so that even when the colloidal silica sol is dried and gelled, it can easily be repulverized by a weak mechanical action, and that it has less tendency to generate coarse silica particle agglomerations, thereby preventing generation of scratches or latent flaws on the surface of silicon wafers during polishing.

### Disclosure of the Invention

In accordance with the present invention which attains the above object, there is provided a silicon wafer polishing compound comprising modified colloidal silica sol, of which part of silanol groups on the surface of silica particles are trialkylsilylated.

### Description of the Preferred Embodiments

The modified colloidal silica sol used in the present invention indicates a colloidal silica sol of which part of silanol groups on the surface of silica particles are trialkylsilylated. Due to the modification, the modified colloidal silica sol makes particle of a silicon wafer polishing compound containing the same less liable to agglomerate and, even once agglomerated, reduces mechanical strength of the agglomerated particles to make them easily redispersible by a small mechanical force.

The inventive silicon wafer polishing compound is used in the form of a slurry in which a modified colloidal silica sol and an unmodified colloidal silica sol (as a whole hereinafter referred to as "silica particles") dispersed in water, of which the concentration of silica particles of the slurry is preferably 1 to 5 % by weight.

The average particle size of the silica particles in the slurry is greater than 5 millimicrons and smaller than 1 micron. If the average particle size is 5 millimicrons or less, the particles tend to have increased amounts of silicic acid monomer and oligomers, which tend to adhere as silica to the surface of silicon wafers and, if the average size is 1 micron or more, they tend to generate scratches on the surface of silicon wafers. Either of these cases is not preferable.

2

The modified colloidal silica in the present invention is obtained by trialkylsilylation of silanol groups on the surface of the silica particles with a trialkylsilane.

The trialkylsilylation of silanol groups on the surface of the silica particles is accomplished by reacting silanol groups on the surface of the silica particles with a trialkylhalosilane or a hexaalkyldisilazane.

Specifically, this is accomplished by reacting silanol groups on the surface of the silica particles with a trialkylhalosilane such as a trialkylchlorosilane, a trialkylbromosilane, a trialkylfluorosilane, or a trialkyliodosilane.

Alternatively, this may be accomplished by reacting silanol groups on the silica particles with a hexaalkyldisilazane.

Hexaalkylsilazane is a compound of a general formula

$R_3$-Si-NH-Si-$R_3$ (wherein R is an alkyl group)

The alkyl group in the alkylsilylation in the present invention may be either a straight-chain alkyl group or a branched alkyl group, having 10 or less carbon atoms, preferably 5 or less carbon atoms. An alkyl group with more than 10 carbon atoms has a problem in reactivity and thus is not practicable in an industrial process. The most preferable alkyl group is methyl. Therefore, trimethylhalosilane and hexamethyldisilazane are preferable.

In the trialkylsilylation of silanol groups on the surface of the silica particles, it is preferable to use a trialkylhalosilane or hexamethyldisilazane in an amount of 0.1 to 10 mole % to the silanol groups on the surface of the silica particles. If less than 0.1 mole % of this compound is used, because the coverage of the silanol groups on the surface of the silica particles are still sufficiently high to form siloxane bonds between the silica particles, the formation of agglomerations in the sol is not suppressed and the dried gel products are hard, which are not desirable for the purpose of the present invention. If more than 10 mole % of the compound is used, due to excessive hydrophobicity of the silica particles, the polishing efficiency tends to lower, which is not desirable.

Yield rate of the reaction between silanol groups and trialkylhalosilane, although depending on the conditions, is more than 30% in an acid solution. If the reaction is carried out in an alkaline solution, the reaction yield of silanol groups and trialkylhalosilane tends to be lowered because a reaction takes place between trialkylsilane molecules to produce ditrialkylsiloxane before trialkylhalosilane reacts with silanol groups on the surface of the silica particles.

The silylation reaction of silanol groups with a trialkylhalosilane releases a halogen compound. When the halogen compound has adverse effects, it is preferable to use a hexaalkyldisilazane.

Reaction between silanol groups and a hexaalkyldisilazane involves hydrolysis of one hexaalkyldisilazane molecule into two molecules of trialkylsilanol, which reacts with the silanol groups on the surface of the silica particles, thus achieving trialkylsilylation.

Yield rate of the reaction between the silanol groups and hexaalkyldisilazane, although depending on the conditions, is more than 30% in an acid solution. If the reaction is carried out in an alkaline solution, the hydrolyzation reaction of hexaalkyldisilazane does not sufficiently proceed and, in turn, formation of the trialkylsilanol is insufficient, reducing the reaction yield of the silanol groups and hexaalkyldisilazane.

While there are various quantitative analysis methods for silanol groups on the surface of the silica particles in the colloidal silica, it is preferable to use a method in which the colloidal silica sol is mixed with a benzene solution of methyl red and, after vigorous agitation, the amount of silanol groups is determined from reduction in concentration of methyl red of the benzene solution. Methyl red concentration in benzene can be determined with good precision by a spectrometric method. Details of this analytical method are described in J. Am. Chem. Soc. 776, 72(1950). The amount of trialkylsilylated silanol groups can be determined from the decrease in amount of trialkylhalosilane of the reaction of silanol groups with trialkylhalosilane. Although this method is difficult to determine the amount of silanol groups at an accuracy of 0.1% or better, since the trialkylsilylation rate of silanol groups is over 0.1% in the present invention, this method is sufficient for the purpose.

Since the trialkylsilylation reaction of silanol groups on the surface of the silica particles is a heterogeneous reaction, the entire surface of the silica particles is not completely trialkylsilylated, but there remain unmodified particles.

Since the modified silica particles contained in the inventive silicon wafer polishing compound are less effective if the content is too small, they are used typically in an amount of 0.1% or more.

The pH value of the slurry-formed polishing compound can be adjusted using an alkali metal, ammonium, or a basic amine. It is preferable to adjust the pH value at 8 to 12, and typically that of 10 to 11 is used for polishing. A pH value higher than 12 tends to roughen the surface, and a pH value lower than 8 tends to have insufficient polishing efficiency. Therefore, either of these cases is not preferable.

To increase the polishing speed, ethylenediamine can be added to the inventive polishing compound. A polyamine such as ethylenediamine, for conventional art colloidal silica sols, has an effect to agglomerate silica particles and is not preferable to add to a polishing compound but, for the inventive polishing compound containing modified colloidal silica sol of which the surface of the silica particles is partly trialkylsilylated, this agglomeration action is considerably suppressed, and such a polyamine can be added.

The present invention provides the following specific effects and can be used to good advantage in industrial applications.

(1) When the inventive polishing compound is used for polishing a silicon wafer, since the slurry-formed compound has a low density of silanol groups on the surface of the silica particles, formation of siloxane bonds between the particles is suppressed and no silica particle agglomerations occur, thus preventing generation of crystal defects due to polishing of the silicon wafer.

(2) Since dried products of the inventive polishing compound have weak siloxane bonds between particles, the dry solid can be readily pulverized by a small force. This is an outstanding effect in view of the fact that dry solids of conventional art colloidal silica sols are hard like glass.

Examples

The present invention will now be described in further detail with reference to the examples and comparative example, but the following examples are intended to illustrate, not limit, the invention.

Example 1

As a colloidal silica sol, 1 kg of "Syton HT-50" (from Mitsubishi Monsanto Chemical, with an average silica particle size of 60 millimicrons and a solid content of 50% by weight) was mixed under effective agitation with 1 g of trimethylchlorosilane, to react the silanol groups on the surface of the silica particles in the silica sol with the trimethylchlorosilane for trimethylsilylation. This reaction releases hydrochloric acid, which increases the hydrogen ion concentration, and the pH value of the sol decreases.

The colloidal silica sol, which is stabilized at an alkaline pH but unstable at a neutral pH, was reacted in the presence of an anionic exchange resin in the reaction system to remove chloride ions released. The anionic exchange resin used was "Dia-Ion SA10A (from Nippon Rensui). The resin was used in an amount of 10 ml. The reaction was carried out at room temperature for over 1 hour. After completion of the reaction, the ion exchange resin was filtered to obtain a modified colloidal silica sol.

Example 2

"Syton HT-50" (same as used in Example 1) was used as a colloidal silica sol, which was previously treated with a cationic exchange resin to remove alkali metal ions from the aqueous phase and to acidify.

1 kg of the acidified colloidal silica sol was mixed under agitation with 1 g of trimethylchlorosilane, to react the silanol groups on the surface of the silica particles in the silica sol with the trimethylchlorosilane for trimethylsilylation.

The reaction was carried out in the presence of an anionic exchange resin to remove chloride ions released. The anionic exchange resin used was "Dia-Ion SA10A (same as used in Example 1). The resin was used in an amount of 10 ml. The reaction was carried out at room temperature for over 1 hour. After completion of the reaction, the ion exchange resin was filtered to obtain a modified colloidal silica sol.

30 g of ethylenediamine was then added to enhance the polishing speed.

Example 3

1 kg of "Syton HT-50" (same as used in Example 1) as a colloidal silica sol, which was previously treated with a cationic exchange resin to remove alkali metal ions from the aqueous phase and to acidify, was mixed under agitation with 50 g of trimethylchlorosilane, to react the silanol groups on the surface of the silica particles in the silica sol with the trimethylchlorosilane for trimethylsilylation. The reaction was carried out in the presence of an anionic exchange resin to remove chloride ions released. The anionic exchange resin used was "Dia-Ion SA10A (same as used in Example 1). The resin was used in an amount of 10 ml. The reaction was carried out at room temperature for over 1 hour. After completion of the reaction, the ion exchange resin was filtered to obtain a modified colloidal silica sol.

30 g of ethylenediamine was then added to enhance the polishing speed.

## Example 4

Using the same procedure as in Example 1, except that 2 g of tripropylchlorosilane was used in place of the 1 g of trimethylchlorosilane, the silanol groups on the surface of the silica sol were reacted with the tripropylchlorosilane. As in Example 1, this reaction also releases hydrochloric acid, which increases the hydrogen ion concentration, and the pH value of the sol decreases.

The colloidal silica sol, which is stabilized at an alkaline pH but unstable at a neutral pH, was reacted in the presence of an anionic exchange resin in the reaction system to remove chloride ions released. The anionic exchange resin used was "Dia-Ion SA10A (from Nippon Rensui). The resin was used in an amount of 10 ml. The reaction was carried out at room temperature for at least 2 hours. After completion of the reaction, the ion exchange resin was filtered to obtain a modified colloidal silica sol.

## Example 5

1 kg of "Syton HT-50" (same as used in Example 1) as a colloidal silica sol was mixed under agitation with 1 g of hexamethyldisilazane, to react the silanol groups on the surface of the silica particles in the silica sol with the hexamethyldisilazane for trimethylsilylation. This reaction releases ammonia, which decreases the hydrogen ion concentration, and the pH value of the sol increases.

The reaction was carried out at room temperature for over 2 hours to obtain a modified colloidal silica sol.

## Example 6

"Syton HT-50" (same as used in Example 1) as a colloidal silica sol, which was previously treated with a cationic exchange resin to remove alkali metal ions from the aqueous phase and to acidify.

1 kg of the acidified colloidal silica sol was mixed under agitation with 1 g of hexamethyldisilazane, to react the silanol groups on the surface of the silica particles in the silica sol with the hexamethyldisilazane for trimethylsilylation.

30 g of ethylenediamine was then added to enhance the polishing speed.

## Example 7

1 kg of "Syton HT-50" (same as used in Example 1) as a colloidal silica sol, which was previously treated with a cationic exchange resin to remove alkali metal ions from the aqueous phase and to acidify, was mixed under agitation with 50 g of hexamethyldisilazane, to react the silanol groups on the surface of the silica particles in the silica sol with the hexamethyldisilazane for trimethylsilylation. The reaction was carried out at room temperature for over 1 hour.

30 g of ethylenediamine was then added to enhance the polishing speed.

## Comparative Example

1 kg of "Syton HT-50" (same as used in Example 1) as a colloidal silica sol was mixed with 30 g of ethylenediamine to obtain a silica sol.

5 ml each of the silica sols described in Examples 1 to 7 and Comparative Example were allowed to stand at 40°C for 1 day to obtain dry solids. These dry solids were tested by pressing with fingers. The results are shown in Table 1.

The silica sols described in Examples 1 to 7 and Comparative Example were diluted with water to 20 times the original volume to obtain slurry-formed polishing compounds, and 15 liters each of these polishing compounds were used as polishing fluids. Polishing was performed while recycling the polishing fluids at a rate of 1.5 l/min. A crystal orientation 100, phosphorus-doped N-type silicon wafer was polished for 20 min, at a polishing pressure of 350 g/cm$^2$, a relative speed between the polishing cloth and the silicon wafer of 1 m/sec, and a polishing fluid temperature of 35°C. The polishing was performed using the Speed Farm SPAW36 polishing machine and a non-woven fabric type polishing cloth.

The polishing speeds and generation of OSF (oxidation stacking fault) are shown in Table 1. OSF occurs during formation of a thermal oxidation film on a silicon wafer due to a high oxidation speed of crystal defects, and the generation of which is used to evaluate the number of crystal defects of the silicon wafer. The greater OSF density means inferior quality.

Table 1

| Sol type | Trialkyl-silylation rate | Pressing test | Polishing speed ($\mu$m/min) | OSF density (pc/cm$^2$) |
|---|---|---|---|---|
| Example 1 | 0.5% | Readily pulverized | 0.5 | 5 |
| Example 2 | 0.7% | Readily pulverized | 1.1 | 10 |
| Example 3 | 21.0% | Readily pulverized | 0.1 | 5 |
| Example 4 | 0.5% | Readily pulverized | 1.0 | 7 |
| Example 5 | 0.5% | Readily pulverized | 0.5 | 5 |
| Example 6 | 0.7% | Readily pulverized | 1.1 | 10 |
| Example 7 | 21.0% | Readily pulverized | 0.1 | 5 |
| Comparative Example | | Divided into glass-like, skin-hurting pieces | 1.1 | 100,000 |

Industrial Applications

The above-described results expressly indicate that the inventive polishing compound, comprising the modified colloidal silica sol with silanol groups on the surface of the silica particles partly trialkylsilylated, has a remarkably reduced hardness of its dried gel product compared to conventional art colloidal silica sols, enables suppressed generation of silica particle agglomeration even in the slurry state and, in high-speed polishing with combined use of ethylenediamine, considerably suppresses generation of OSF.

**Claims**

1. A silicon wafer polishing compound comprising a modified colloidal silica sol having part of silanol groups trialkylsilylated on the surface of silica particles of said colloidal silica sol.

2. The silicon wafer polishing compound of Claim 1 wherein said silica particles of said colloidal silica sol have an average particle diameter of 5 millimicrons to 1 micron.

3. The silicon wafer polishing compound of Claim 1 wherein said trialkylsilylated modified colloidal silica sol is trimethylsilylated modified colloidal silica sol.

4. The silicon wafer polishing compound of Claim 1 wherein 0.1% to 10% of said silanol groups distributed on the surface of said silica particles of said modified colloidal silica sol are trialkylsilylated.

5. The silicon wafer polishing compound of Claim 1 wherein trialkylsilylation is made using a trialkylhalosilane.

6. The silicon wafer polishing compound of Claim 1 wherein trialkylsilylation is made using a hexaalkyldisilazane.

7. The silicon wafer polishing compound of Claim 1 wherein the content of said silica particles is 0.1% by weight or more of said compound.

8. The silicon wafer polishing compound of Claim 1 wherein the pH value of said compound is adjusted at 8 to 12.

## Patentansprüche

1. Verbindung zum Polieren von Siliciumscheiben, umfassend ein modifiziertes kolloidales Silicasol, wo ein Teil der Silanolgruppen auf der Oberfläche der Silicateilchen des kolloidalen Silicasols trialkylsilyliert ist.

2. Verbindung zum Polieren von Siliciumscheiben nach Anspruch 1, dadurch gekennzeichnet, daß die Silicateilchen des kolloidalen Silicasols einen durchschnittlichen Teilchendurchmesser von 5 nm bis 1 μm besitzen.

3. Verbindung zum Polieren von Siliciumscheiben nach Anspruch 1, dadurch gekennzeichnet, daß das trialkylsilylierte modifizierte kolloidale Silicasol trimethylsilyliertes modifiziertes kolloidales Silicasol ist.

4. Verbindung zum Polieren von Siliciumscheiben nach Anspruch 1, dadurch gekennzeichnet, daß 0,1% bis 10% der auf der Oberfläche der Silicateilchen des modifizierten kolloidalen Silicasols verteilten Silanolgruppen trialkylsilyliert sind.

5. Verbindung zum Polieren von Siliciumscheiben nach Anspruch 1, dadurch gekennzeichnet, daß die Trialkylsilylierung unter Verwendung von Trialkylhalosilan erfolgt.

6. Verbindung zum Polieren von Siliciumscheiben nach Anspruch 1, dadurch gekennzeichnet, daß die Trialkylsilylierung unter Verwendung von Hexaalkyldisilazan erfolgt.

7. Verbindung zum Polieren von Siliciumscheiben nach Anspruch 1, dadurch gekennzeichnet, daß der Anteil der Silicateilchen an der Verbindung 0,1 Gew.-% oder mehr beträgt.

8. Verbindung zum Polieren von Siliciumscheiben nach Anspruch 1, dadurch gekennzeichnet, daß der pH-Wert der Verbindung auf 8 bis 12 eingestellt ist.

## Revendications

1. Composé de polissage d'une pastille de silicium comportant un sol de silice colloïdale modifiée dont une partie des groupes silanol sont trialkylsilylés sur la surface de particules de silice dudit sol de silice colloïdale.

2. Composé de polissage d'une pastille de silicium selon la revendication 1, dans lequel lesdites particules de silice dudit sol de silice colloïdale possèdent un diamètre de particules moyen de 5 millimicrons à 1 micron.

3. Composé de polissage d'une pastille de silicium selon la revendication 1, dans lequel ledit sol de silice colloïdale modifiée trialkylsilylée est un sol de silice colloïdale modifiée triméthylsilylée.

4. Composé de polissage d'une pastille de silicium selon la revendication 1, dans lequel 0,1 % à 10 % desdits groupes silanol répartis sur la surface desdites particules de silice dudit sol de silice colloïdale modifiée sont trialkylsilylés.

5. Composé de polissage d'une pastille de silicium selon la revendication 1, dans lequel la trialkylsilylation est effectuée en utilisant un trialkylhalosilane.

6. Composé de polissage d'une pastille de silicium selon la revendication 1, dans lequel la trialkylsilylation est effectuée en utilisant un hexaalkyldisilazane.

7. Composé de polissage d'une pastille de silicium selon la revendication 1, dans lequel la teneur dudit composé en lesdites particules de silice est 0,1 % en poids ou plus.

8. Composé de polissage d'une pastille de silicium selon la revendication 1, dans lequel le pH dudit composé est réglé à une valeur de 8 à 12.